# EUROPEAN PATENT SPECIFICATION

(11) **EP 4 057 787 B1**
(45) Date of publication and mention of the grant of the patent: **09.10.2024**
(21) Application number: 21382191.1
(22) Date of filing: 08.03.2021
(51) Int. Cl.: H05K 7/14

(54) **SUPPORT BRACKET ASSEMBLY FOR PRINTED CIRCUIT BOARDS**
STÜTZKLAMMERANORDNUNG FÜR LEITERPLATTEN
ENSEMBLE CONSOLE DE SUPPORT POUR CARTES DE CIRCUIT IMPRIMÉ

(43) Date of publication of application: 14.09.2022
(73) Proprietor: Fico Triad, S.A., 08028 Barcelona (ES)
(72) Inventor: TRULLÀS JIMÉNEZ, Albert, 08028 Barcelona (ES)
(74) Representative: Hoffmann Eitle

(56) References cited:
- US-A1- 2008 018 485

## Description

### Field and object of the invention

The present invention refers in general to the installation and fixation of printed circuit boards (PCB's), in devices or vehicles wherein a PCB is meant to be used.

An object of the invention is to reduce PCB's manufacturing costs, by reducing PCB size, that is PCB material, and simplifying PCB's shape.

### Background of the invention

Conventionally, printed circuit boards (PCB's) are mechanically installed inside an apparatus during the fabrication of the same, by means of screws or clipping means, in specific areas of the apparatus suitable for that purpose.

In some applications, the size and shape of a PCB is not only defined by the need to allocate electronic components of a circuit and for their electrical connection, but also by the need to mechanically attach the PCB to an external structure, like an apparatus or a vehicle wherein the PCB is to be installed.

Therefore, for attaching a PCB to an external structure, commonly, the area of the board of a PCB has to be shaped and dimensioned to reach specific parts of an apparatus wherein a part of the board of a PCB can be screwed or fixed in a suitable manner. Frequently, this means that the area of the board has to be enlarged so that additional board material, typically fibre glass and copper, are actually used not for the construction of an electronic circuit, but as attachment areas.

In addition, for the same reason, the shape of the boards of PCB¨s usually has irregular shapes, which means that a large amount of material of a mother board plank from which a plurality of individual boards are cut-off during the manufacturing process of PCB's, is wasted.

The U. S. Patent publication US-2008/018485 A1 discloses a particle sensor, comprising: a light source, an optical transducer and a controller in communication with said light source and said optical transducer, said controller is configured to reject substantially all signals except those contributed by said light source. The particle sensor further comprises a chimney, an aesthetic cover, a circuit board, and a smoke cage at least partially defined by at least a portion of said chimney.

### Summary of the invention

The invention is defined in the attached independent claim, and satisfactorily solves the above-mentioned shortcomings of the prior art, by providing a PCB assembly in which a major part of the area of the board of a PCB is dedicated to the installation of the electronic components and connection tracks of an electronic circuit. For the attachment of the PCB, a dedicated support bracket made of a less expensive material than the PCB, is designed for the mechanical attachment of the PCB to the apparatus or vehicle in which the PCB is to be installed.

In this way, the use of the relatively expensive materials of a PCB, typically fiber glass and copper, is optimized, and fabrication costs are reduced and manufacturing is simplified since the PCB can be fabricated with regular shapes like rectangular or square.

Therefore, an aspect of the invention refers to a support bracket assembly for printed circuit boards, wherein the assembly comprises a printed circuit board and a support bracket having attaching means preferably configured to allow the attachment of the support bracket to an external structure, other than the PCB, for example a part of an apparatus on which the PCB is to be installed. It should be clarified here, that the referred external structure is not part of the invention.

According to the invention, the support bracket and the printed circuit board are configured such that they can be coupled together, that is, parts of an area of the PCB and the support bracket are overlapped and in direct contact.

In addition, the assembly further comprises coupling means for mechanically coupling the support bracket and the printed circuit board together, such that the printed circuit board is supported and retained by the support bracket. In this way, the PCB is supported in an external structure solely by means of the support bracket, so that the shape and dimensions of the board of the PCB can be freely designed to optimize the use of material and without considering its installation in an apparatus, because the installation of the PCB is carried out by means of the support bracket produced with cheap material, for example plastic, a light metallic material like aluminium or a combination of both.

In a preferred embodiment, at least a part of the support bracket is made of metallic material, and the printed circuit board has a heat sink arranged to be in contact with the metallic part of the support bracket, such that heat can be transferred from the heat sink to the metallic part of the support bracket to enhance heat dissipation. In this case, the support bracket is not only used for its main purpose of supporting the PCB, but also to contribute with the operation of the PCB, in this case to dissipate heat generated by some of electronic components of the PCB, and even for the heat transfer between the support bracket and an external structure on which the support bracket would be attached in a practical use of the same.

For the coupling between the support bracket and the PCB, both components are complementarily designed, such that a part of the support bracket is shaped and dimensioned to match a part of the printed circuit board, so that the printed circuit board can be received in the support bracket.

Furthermore, the support bracket is configured such that, when the support bracket and the printed circuit board are coupled together, in a plan view of the assembly, at least one extension part of the support bracket protrudes outside the perimeter or edges of the board of the PCB, that is, the support bracket and the board do not overlap at these extension parts.

The attaching means of the support bracket are provided in that extension part. In this way, the attachment areas of the assembly are distanced from the PCB and do not interfere with the electronic circuit.

In an embodiment of the invention, the attaching means consist of a passing-trough perforation in the extension part, for attaching the support bracket to an external surface by means of screws. In addition or alternatively, the attaching means are clipping means.

Additionally, the support bracket has at least one aperture or window. Preferably, the board of the printed circuit board has a passing-through opening overlapped with that aperture of the support bracket, for allowing ventilation from one side of the assembly to the other side. This would avoid heat accumulation at one side of the assembly.

In an embodiment of the invention, the support bracket has at least one opening for reducing its weight. Preferably, the total volume of one or more openings, is at least 50%, more preferably at least 70%, and more preferably at least 85 % of the total volume of the support bracket. One or more of these openings in the support bracket for reducing its weight, do not overlap with an opening of the PCB, that is, they are covered by the PCB.

In another preferred embodiment of the invention, the board of the printed circuit board has at least one opening, and the support bracket has at least one wall inserted at least in part in the opening for attaching or centering the printed circuit board to the support bracket. Having the wall inserted in the opening, preferably at a central area of the PCB, avoids vibrations of the PCB and provides a fixation point for the same.

Preferably, the wall is configured as a tube orthogonally extending with respect to the support bracket, and optionally the wall has a lib configured to retain the board attached to the support bracket, and optionally the tube is a pass-through hollow that communicates both sides of the support bracket.

In a preferred embodiment, the support bracket has a chimney passing-through the board, in a way that a channel of the chimney communicates both sides of the assembly for allowing air passing from one side of the assembly to the other side. The provision of this chimney further enhance ventilation through the assembly.

### Brief description of the drawings

Preferred embodiments of the invention are henceforth described with reference to the accompanying drawings, wherein:
Figure 1.- shows a perspective view of an exemplary embodiment of a support bracket assembly according to the invention.
Figure 2.- shows another perspective view of the assembly of Figure 1.
Figure 3.- shows in a longitudinal cross-sectional view, a schematic representation of a support bracket assembly according to the invention. This figure shows a collection of features that for the sake of simplicity have been represented in the same figure, but it should be understood that several embodiments of the invention include any combination of one or more of the features that are explained in the following section. In Figure 3, extension parts are identified by dotted circumferences.

### Preferred embodiment of the invention

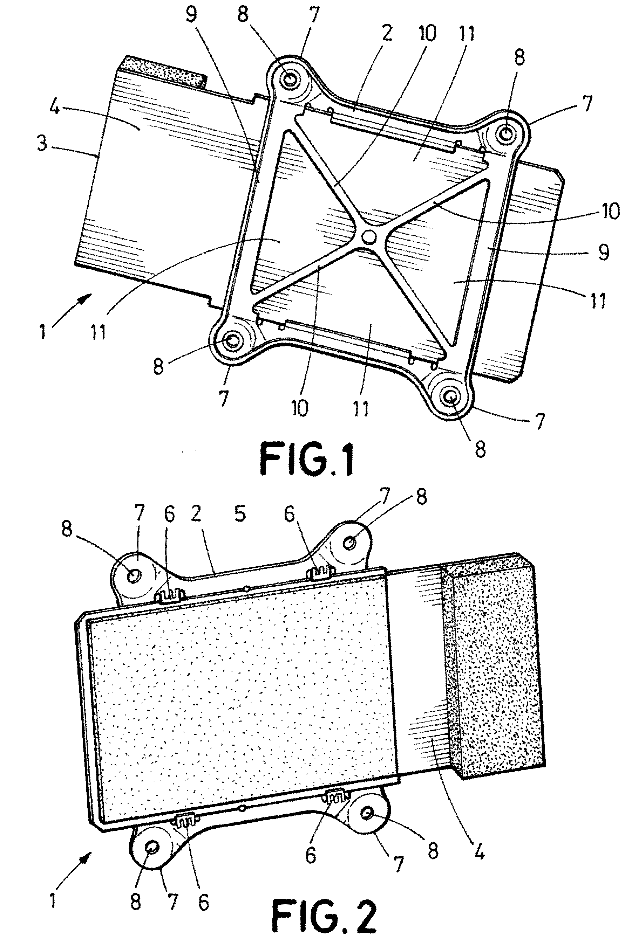

**Figures 1** and **2** show an exemplary implementation of a support bracket assembly (1) according to the invention, that comprises a support bracket (2) made of a plastic material, and a printed circuit board (3) conventionally comprising a board (4) and electronic components (5) and optionally a connector (19) fitted to the board (4), conventionally welded to connection tracks of the PCB.

The support bracket (2) and a printed circuit board (3) are both complementary configured, such that they can be coupled together as shown in the figures.

The assembly (1) includes coupling means (12) for mechanically coupling the support bracket (2) and the printed circuit board (3) together. In the embodiment of **Figures 1,2****,** these coupling means (12) are realized as clipping means (6) in the form of elastic tongues that retain the board (4) of the PCB at its edges by elastic pressure in a known manner. For that, the board (4) of the PCB is shaped and dimensioned, so as to get coupled with the support bracket (2) by clipping or snap-fitting, by pressing the board (4) down against the clipping means (6).

For attaching the assembly (1) to an external structure of an apparatus or vehicle (not shown) during the manufacturing process of the same, the support bracket (2) has two or more extension parts (7) located to overlap with fixation areas (not shown) of the apparatus on which the assembly is to be fixed. These extension parts (7) are integrally formed with the support bracket (2), and are arranged in the same, such that when the support bracket (2) and the PCB (3) are coupled together, in a plan view of the assembly (1), at least one extension part (7) protrudes outside the perimeter of the board (4) of the PCB (3) as shown in the Figures.

The attaching means of the support bracket (2) are provided in those extension parts (7), and this implementation of the invention consist of passing-through holes (8), that would allow attaching the assembly (1) to an external structure by means of screws.

During the design of the assembly, these extension parts (7) are shaped and positioned depending on each practical application, so that the same PCB can be installed in different vehicle models simply by shaping the support bracket accordingly.

In the embodiment illustrated in **Figures 1, 2****,** the support bracket (2) is generally a planar body having a four-sided frame (9). Inside the area defined by the frame (9), there are apertures, in this example four triangular apertures (11) defined by crossbars (10).

The support bracket (2) has four extension parts (7) at the corners of the frame (9), such that these extension parts (7) protrude outside the edges of the frame (9).

With this configuration of the support bracket (2), the board (4) of the PCB can be fabricated with a rectangular configuration, which is very convenient to optimize the use of a mother board plank from which individual boards are cut-off.

As it can be observed in **Figures 1,2****,** the PCB (4) is rectangular and the support bracket (2) is squared, and one side of the support bracket (2) (including the extension parts (7)), is longer than first sides of the board (4) of the PCB, and the other side of the support bracket (2) is shorter than at least one second side of the board (4) of the PCB (3).

There are four clipping means (6) arranged in pairs at opposite sides of the frame (9). The length of one side of the frame (9), is similar to the length of the sort side of the board (4) of the PCB (3), in a way that the board (4) can be retained by the clipping means (6) at opposite sides.

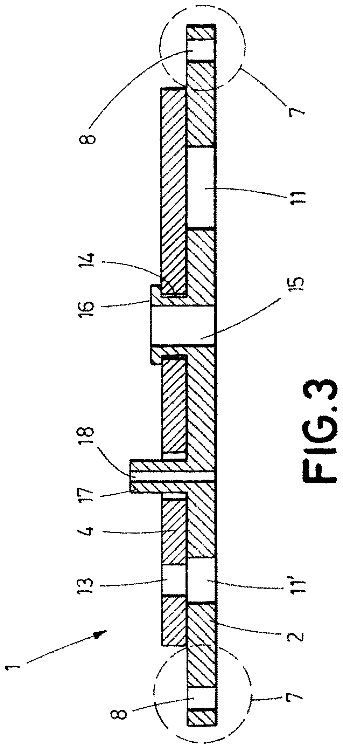

As shown in **Figure 3****,** the support bracket (2) preferably has at least one aperture (11,11'). The board (4) of the printed circuit board has at least one passing-through opening (13) overlapped with one aperture (11'), for allowing ventilation from one side of the assembly (1) to the other side.

In other preferred embodiments, the support bracket (2) has at least one aperture (11) which does not overlap with an opening of the printed circuit board, that is, it is covered by the PCB.

Preferably, the board (4) of the printed circuit board has at least one opening (14), and the support bracket (2) has one wall (15) inserted at least in part in that opening (14) for attaching the board (4) firmly to the support bracket (2). Preferably, the wall (15) is a cylindrical tube, and it has a lib (16) configured to retain the board (4) attached to the support bracket (2) as shown in **Figure 3****.**

The wall (15) configured as a cylindrical tube extends orthogonally with respect to the support bracket (2), and it also serves for ventilation as previously explained.

Also, as shown in **Figure 3****,** the support bracket (2) has extension parts (7) which are parts that extend beyond the edges of perimeter of the board (4), such that the support bracket (2) and the board (4) do not overlap at these extension parts (7).

The attaching means (8) of the support bracket (2), in this embodiment are passing-through holes provided in the extension parts (7).

Preferably, as shown in **Figure 3** the support bracket (2) has a chimney (17) passing-through the board (4), in a way that the channel (18) of the chimney (17), communicates both sides of the assembly (1) for allowing air passing from one side of the assembly to the other side. The provision of this chimney (17) dimensioned to generate a chimney effect in a known manner, further enhance ventilation through the assembly due to the chimney effect.

Preferably, the length of chimney is larger than the height of the components fitted to the PCB, when attached to the support bracket, that is, the outlet of the chimney is above the components fitted to the PCB. This configuration of the chimney prevents that heat passing from one side of the PCB to the other side, would affect the PCB components.

Other preferred embodiments of the present invention are described in the appended dependent claims and the multiple combinations of those claims.

## Claims

1. A support bracket assembly (1) for printed circuit boards, comprising:
a dedicated support bracket (2) having attaching means (8) configured to allow the attachment of the support bracket (2) to an external structure,
a printed circuit board (3),
wherein the support bracket (2) and the printed circuit board (3) are configured such that they can be coupled together, and
coupling means (12) for mechanically coupling the support bracket (2) and the printed circuit board (3) together, such that the printed circuit board (3) is supported and retained by the support bracket (2),
**characterized in that** parts of an area of the printed circuit board (3) and the support bracket (2) are overlapped and in direct contact, and
wherein the support bracket (2) is configured such that, when the support bracket (2) and the printed circuit board (3) are coupled together, in a plan view of the assembly, at least one extension part (7) of the support bracket (2) protrudes outside the perimeter of a board (4) of the printed circuit board (3), and wherein the attaching means (8) of the support bracket (2) are provided **in that** extension part (7).

2. A support bracket assembly (1) according to claim 1, wherein a part of the support bracket (2) is shaped and dimensioned to match a part of the printed circuit board (3), so that the printed circuit board (3) is received in the support bracket (2) and overlaps with the support bracket (2).

3. A support bracket assembly (1) according to any of the preceding claims, wherein the attaching means (8) is a passing-through holes for attaching the support bracket (2) to the external structure by means of screws.

4. A support bracket assembly (1) according to any of the preceding claims, wherein the coupling means (12) comprise clipping means (6) and/or screws.

5. A support bracket assembly (1) according to any of the preceding claims, wherein the support bracket (2) is made of an electrically insulating material.

6. A support bracket assembly (1) according to any of the preceding claims, wherein at least a part of the support bracket (2) is made of metallic material, and wherein the printed circuit board (3) has a heat sink arranged to be in contact with the metallic part of the support bracket (2), such that heat can be transferred from the heat sink to the metallic part of the support bracket (2) to enhance heat dissipation.

7. A support bracket assembly (1) according to any of the preceding claims, wherein the support bracket (2) has at least one aperture (11') and wherein the board (4) of the printed circuit board has a passing-through opening (13) overlapped with that aperture (11'), for allowing ventilation from one side of the assembly (1) to the other side.

8. A support bracket assembly (1) according to any of the preceding claims, wherein the board (4) of the printed circuit board has at least one opening (14), and the support bracket (2) has one wall (15) inserted at least in part in that opening (14) for attaching the board (4) firmly to the support bracket (2).

9. A support bracket assembly (1) according to claim 8, wherein the wall (15) is a tube orthogonally extending with respect to the support bracket (2),

10. A support bracket assembly (1) according to any of the preceding claims, wherein the support bracket (2) has a frame (9) having at least one aperture (11) in an area defined inside the frame.

11. A support bracket assembly (1) according to claim 10, wherein the frame (9) has at least one extension part (7) protruding outside the frame (9).

12. A support bracket assembly (1) according to any of the preceding claims, wherein at least one aperture (11) for reducing its weight, and wherein the total volume of one or more of these apertures is at least 50% of the total volume of the support bracket, and wherein one or more of these apertures are covered by the PCB.

13. A support bracket assembly (1) according to any claims 10-12, wherein the frame (9) of the support bracket (2) has a rectangular or squared configuration.

14. A support bracket assembly (1) according to any of the preceding claims, wherein the support bracket (2) has a chimney (17) passing-through the board (4), in a way that the chimney (17) communicates both sides of the assembly (1) for allowing air passing from one side of the assembly to the other side.

## Patentansprüche

1. Stützklammeranordnung (1) für Leiterplatten, umfassend:
eine dedizierte Stützklammer (2) aufweisend Befestigungsmittel (8), welche dazu ausgebildet sind, die Befestigung der Stützklammer (2) an einer äußeren Struktur zu erlauben,
eine Leiterplatte (3),
wobei die Stützklammer (2) und die Leiterplatte (3) so ausgebildet sind, dass sie miteinander gekoppelt werden können, und
Kopplungsmittel (12) zur mechanischen Kopplung der Stützklammer (2) und der Leiterplatte (3) miteinander, sodass die Leiterplatte (3) von der Stützklammer (2) gestützt und gehalten wird,
**dadurch gekennzeichnet, dass** sich Teile eines Bereichs der Leiterplatte (3) und der Stützklammer (2) überlappen und in direktem Kontakt sind, und
wobei die Stützklammer (2) so ausgebildet ist, dass, wenn die Stützklammer (2) und die Leiterplatte (3) miteinander gekoppelt sind, in einer Draufsicht der Anordnung, mindestens ein Erstreckungsteil (7) der Stützklammer (2) außerhalb des Umfangs einer Platte (4) der Leiterplatte (3) hervorsteht, und wobei die Befestigungsmittel (8) der Stützklammer (2) in diesem Erstreckungsteil (7) vorgesehen sind.

2. Stützklammeranordnung (1) nach Anspruch 1, wobei ein Teil der Stützklammer (2) geformt und dimensioniert ist, um mit einem Teil der Leiterplatte (3) übereinzustimmen, sodass die Leiterplatte (3) in der Stützklammer (2) aufgenommen ist und sich mit der Stützklammer (2) überlappt.

3. Stützklammeranordnung (1) nach einem der vorhergehenden Ansprüche, wobei die Befestigungsmittel (8) Durchgangslöcher sind, um die Stützklammer (2) an der äußeren Struktur mittels Schrauben zu befestigen.

4. Stützklammeranordnung (1) nach einem der vorhergehenden Ansprüche, wobei die Kopplungsmittel (12) Klemmmittel (6) und/oder Schrauben umfassen.

5. Stützklammeranordnung (1) nach einem der vorhergehenden Ansprüche, wobei die Stützklammer (2) aus einem elektrisch isolierenden Material hergestellt ist.

6. Stützklammeranordnung (1) nach einem der vorhergehenden Ansprüche, wobei mindestens ein Teil der Stützklammer (2) aus metallischem Material hergestellt ist, und wobei die Leiterplatte (3) eine Wärmesenke aufweist, welche dazu angeordnet ist, in Kontakt mit dem metallischen Teil der Stützklammer (2) zu sein, sodass Wärme von der Wärmesenke auf den metallischen Teil der Stützklammer (2) übertragen werden kann, um die Wärmeabfuhr zu erhöhen.

7. Stützklammeranordnung (1) nach einem der vorhergehenden Ansprüche, wobei die Stützklammer (2) mindestens eine Öffnung (11') aufweist und wobei die Platte (4) der Leiterplatte eine Durchgangsbohrung (13) aufweist, welche sich mit dieser Öffnung (11') überlappt, um die Belüftung von einer Seite der Anordnung (1) zur anderen Seite zu erlauben.

8. Stützklammeranordnung (1) nach einem der vorhergehenden Ansprüche, wobei die Platte (4) der Leiterplatte mindestens eine Bohrung (14) aufweist, und die Stützklammer (2) eine Wand (15) aufweist, welche mindestens teilweise in diese Bohrung (14) eingeführt ist, um die Platte (4) fest an der Stützklammer (2) zu befestigen.

9. Stützklammeranordnung (1) nach Anspruch 8, wobei die Wand (15) ein Rohr ist, welches sich orthogonal in Bezug auf die Stützklammer (2) erstreckt.

10. Stützklammeranordnung (1) nach einem der vorhergehenden Ansprüche, wobei die Stützklammer (2) einen Rahmen (9) aufweist, welcher mindestens eine Öffnung (11) in einem innerhalb des Rahmens definierten Bereich aufweist.

11. Stützklammeranordnung (1) nach Anspruch 10, wobei der Rahmen (9) mindestens einen Erstreckungsteil (7) aufweist, welcher außerhalb des Rahmens (9) hervorsteht.

12. Stützklammeranordnung (1) nach einem der vorhergehenden Ansprüche, aufweisend mindestens eine Öffnung (11) zur Verringerung deren Gewichts, und wobei das Gesamtvolumen einer oder mehrerer dieser Öffnungen mindestens 50 % des Gesamtvolumens der Stützklammer ist, und wobei eine oder mehrere dieser Öffnungen von der Leiterplatte gedeckt sind.

13. Stützklammeranordnung (1) nach einem der Ansprüche 10-12, wobei der Rahmen (9) der Stützklammer (2) eine rechteckige oder quadratische Ausbildung aufweist.

14. Stützklammeranordnung (1) nach einem der vorhergehenden Ansprüche, wobei die Stützklammer (2) einen Kamin (17) aufweist, welcher derart durch die Platte (4) durchgeht, dass der Kamin (17) beide Seiten der Anordnung (1) kommuniziert, um zu erlauben, dass Luft von einer Seite der Anordnung zur anderen Seite durchgeht.

## Revendications

1. Ensemble console de support (1) pour cartes de circuit imprimé, comprenant :
une console de support (2) dédiée ayant des moyens de fixation (8) configurés pour permettre la fixation de la console de support (2) à une structure externe,
une carte de circuit imprimé (3),
dans lequel la console de support (2) et la carte de circuit imprimé (3) sont configurés de telle sorte qu'ils peuvent être couplés ensemble, et
des moyens de couplage (12) pour coupler mécaniquement la console de support (2) et la carte de circuit imprimé (3) ensemble, de telle sorte que la carte de circuit imprimé (3) est supportée et retenue par la console de support (2),
**caractérisé en ce que** des parties d'une zone de la carte de circuit imprimé (3) et la console de support (2) sont superposées et en contact direct, et
dans lequel la console de support (2) est configurée de telle sorte que, lorsque la console de support (2) et la carte de circuit imprimé (3) sont couplés ensemble, dans une vue en plan de l'ensemble, au moins une partie d'extension (7) de la console de support (2) dépasse à l'extérieur du périmètre d'une carte (4) de la carte de circuit imprimé (3), et dans lequel les moyens de fixation (8) de la console de support (2) sont fournis dans cette partie d'extension (7).

2. Ensemble console de support (1) selon la revendication 1, dans lequel une partie de la console de support (2) est formée et dimensionnée pour correspondre à une partie de la carte de circuit imprimé (3), de manière que la carte de circuit imprimé (3) est reçue dans la console de support (2) et superposé à la console de support (2).

3. Ensemble console de support (1) selon l'une quelconque des revendications précédentes, dans lequel les moyens de fixation (8) sont des trous traversants pour fixer la console de support (2) à la structure externe au moyen de vis.

4. Ensemble console de support (1) selon l'une quelconque des revendications précédentes, dans lequel les moyens de couplage (12) comprennent des moyens de clipsage (6) et/ou des vis.

5. Ensemble console de support (1) selon l'une quelconque des revendications précédentes, dans lequel la console de support (2) est faite d'un matériau électriquement isolant.

6. Ensemble console de support (1) selon l'une quelconque des revendications précédentes, dans lequel au moins une partie de la console de support (2) est faite d'un matériau métallique, et dans lequel la carte de circuit imprimé (3) comporte un dissipateur de chaleur prévu pour être en contact avec la partie métallique de la console de support (2), de telle sorte que la chaleur peut être transférée depuis le dissipateur de chaleur à la partie métallique de la console de support (2) pour améliorer la dissipation de chaleur.

7. Ensemble console de support (1) selon l'une quelconque des revendications précédentes, dans lequel la console de support (2) a au moins une ouverture (11') et dans lequel la carte (4) de la carte de circuit imprimé a une ouverture traversante (13) superposée avec cette ouverture (11'), pour permettre la ventilation depuis un côté de l'ensemble (1) à l'autre côté.

8. Ensemble console de support (1) selon l'une quelconque des revendications précédentes, dans lequel la carte (4) de la carte de circuit imprimé a au moins une ouverture (14), et la console de support (2) a une paroi (15) insérée au moins en partie dans cette ouverture (14) pour fixer fermement la carte (4) à la console de support (2).

9. Ensemble console de support (1) selon la revendication 8, dans lequel la paroi (15) est un tube s'étendant orthogonalement par rapport à la console de support (2).

10. Ensemble console de support (1) selon l'une quelconque des revendications précédentes, dans lequel la console de support (2) a un cadre (9) ayant au moins une ouverture (11) dans une zone définie à l'intérieur du cadre.

11. Ensemble console de support (1) selon la revendication 10, dans lequel le cadre (9) a au moins une partie d'extension (7) qui dépasse à l'extérieur du cadre (9).

12. Ensemble console de support (1) selon l'une quelconque des revendications précédentes, dans lequel au moins une ouverture (11) pour réduire son poids, et dans lequel le volume total d'une ou plusieurs de ces ouvertures est au moins de 50 % du volume total de la console de support, et dans lequel une ou plusieurs de ces ouvertures sont couvertes par la PCB.

13. Ensemble console de support (1) selon l'une quelconque des revendications 10-12, dans lequel le cadre (9) de la console de support (2) a une configuration rectangulaire ou carrée.

14. Ensemble console de support (1) selon l'une quelconque des revendications précédentes, dans lequel la console de support (2) a une cheminée (17) traversant la carte (4), de telle manière que la cheminée (17) communique les deux côtés de l'ensemble (1) pour permettre le passage d'air depuis un côté de l'ensemble à l'autre côté.
